# FASCICULE DE BREVET EUROPEEN

(11) **EP 2 664 931 B1**
(45) Date de publication et mention de la délivrance du brevet: **02.09.2015**
(21) Numéro de dépôt: 13305617.6
(22) Date de dépôt: 16.05.2013
(51) Int. Cl.: G01R 21/133, G01D 4/00, B60L 11/18

(54) **Prise en compte de l'équipement aval dans le suivi d'une consommation électrique**
Berücksichtigung von verbraucherseitig angeordneten Ausrüstungen beim Verlauf eines elektrischen Verbrauchs
Accounting of load side equipment for the evolution of an electric consumption

(30) Priorité: 16.05.2012 FR 1254526
(43) Date de publication de la demande: 20.11.2013
(73) Titulaire: Hager-Electro SAS (Société par Actions Simplifiée), 67210 Obernai (FR)
(72) Inventeur: Gancel, Etienne, 25660 Morre (FR)
(74) Mandataire: Nuss, Laurent

(56) Documents cités:
- EP-A1- 1 136 829
- EP-A1- 2 099 002
- EP-A1- 2 182 607
- US-A- 5 742 229
- US-A1- 2009 163 136
- US-A1- 2012 013 301

## Description

La présente invention relève du domaine des installations électriques, et a pour objet un dispositif de suivi de consommation, un équipement électrique le comprenant, un procédé de suivi, ainsi qu'un procédé de tarification particuliers.

Dans le domaine de la fourniture d'énergie, en particulier d'énergie électrique, la facturation par le fournisseur se fait sur la base de la consommation relevée et mémorisée par le compteur de l'installation. Un prix fixe par unité d'énergie peut être utilisé, ou, pour des facturations plus élaborées, le prix associé à une unité d'énergie dépend de la période au cours de laquelle l'énergie a été fournie. Ainsi, par exemple, l'énergie consommée en dehors des périodes de fortes consommations à l'échelle nationale peut être moins chère.

Dans ce domaine, FR 2 365 129 propose par exemple un compteur muni de plusieurs registres de mémorisation, chacun étant associé à une plage horaire prédéfinie, pour laquelle un tarif spécial doit être appliqué. La consommation est mémorisée pour chacune des plages horaires, puis la tarification globale est faite en affectant à chacune de ces plages le tarif par unité d'énergie qui lui est propre.

Le tarif appliqué à l'énergie consommée peut donc être une forme d'incitation à un mode de consommation cible, qui est actuellement essentiellement basé sur une répartition de la consommation dans le temps pour éviter les surcharges ponctuelles du réseau. A titre d'exemple, US 5 786 683, FR 2 719 440 ou encore WO 2011 160815 proposent ainsi des appareils qui ne permettent la fourniture d'électricité que si le tarif en cours est inférieur à un seuil. GB 2 314 935 propose, quant à lui, de quantifier la consommation sous la forme d'un facteur de charge moyen, sur la base duquel un tarif peut être associé, ce qui peut donc inciter l'utilisateur à éviter les surcharges ponctuelles qu'il génère. En outre les documents suivants forment l'art antérieur: EP 2 099 002 A1, US 2012/013301, US 5 742 229 A, EP 2 182 607 A1, US 2009/163136 A1, EP 1 136 829 A1, EP 2 099 002 A1, US 2012/013301 A1, US 5 742 229 A, EP 2 182 607 A1.

Cependant, il est souhaitable d'utiliser le tarif de l'énergie pour inciter à utiliser ou éviter tel ou tel équipement électrique dans une installation domestique, ou encore, par exemple, pour tenir compte de taxes légales différentes, associées à l'utilisation de tel ou tel type d'équipement électrique : appareil électrique de chauffage, véhicule électrique, appareil électroménager particulier, outillage électrique, etc. Il est donc souhaitable de pouvoir moduler le tarif associé à l'électricité en fonction des équipements qui la consomment. Par conséquent, le fonctionnement du compteur central doit pouvoir dépendre des équipements électriques branchés en aval.

La présente invention vise à améliorer l'état de la technique de la façon décrite ci-dessus, en tenant compte, dans le suivi de la consommation en vue de la tarification, de l'utilisation faite de l'électricité en aval du compteur.

A cet effet, l'invention a tout d'abord pour objet un dispositif de suivi de la consommation d'énergie électrique dans une installation électrique alimentée à partir du réseau, comprenant un compteur ainsi que des équipements électriques consommateurs branchés en aval de façon au moins temporaire, ledit compteur étant apte à communiquer, avec ou sans fil, de sorte à au moins pouvoir recevoir une information.

Ce dispositif est **caractérisé en ce qu'il** comprend un émetteur de signal pour communiquer avec le compteur et fournir une information de consigne tarifaire au compteur électrique, ledit dispositif étant destiné à être placé dans l'installation, au moins temporairement, en aval dudit compteur.

L'invention a aussi pour objet un équipement électrique, destiné à être branché et alimenté temporairement ou de façon permanente dans une installation, comprenant un tel dispositif de suivi.

L'invention a encore pour objet un procédé de suivi de la consommation d'énergie électrique dans une installation électrique alimentée à partir du réseau, comprenant un compteur ainsi que des équipements électriques consommateurs branchés en aval de façon au moins temporaire, ledit compteur étant apte à communiquer, avec ou sans fil, de sorte à au moins pouvoir recevoir une information, le procédé comprenant
- une étape de paramétrage, consistant essentiellement à fournir une information de consigne tarifaire au compteur électrique,
- une étape de mesure consistant essentiellement à mesurer la quantité d'énergie électrique consommée, et
- une étape de mémorisation, consistant essentiellement à mémoriser au moins la consommation mesurée au niveau du compteur.

Ce procédé est **caractérisé en ce que** l'information de consigne tarifaire est fournie au compteur électrique depuis l'aval de l'installation.

L'invention a enfin pour objet un procédé de tarification de la consommation d'énergie électrique dans une installation électrique alimentée à partir du réseau, comprenant un compteur ainsi que des équipements électriques consommateurs branchés en aval de façon au moins temporaire, ledit compteur étant apte à communiquer, avec ou sans fil, de sorte à au moins pouvoir recevoir une information, le procédé comprenant
- une étape de consultation consistant essentiellement à relever l'information mémorisée par le compteur,
- une étape de quantification consistant essentiellement à définir un prix total pour l'énergie consommée.

Ce procédé est **caractérisé en ce que** le prix défini par la quantification tient compte du type d'équipement électrique qui a consommé l'énergie.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :

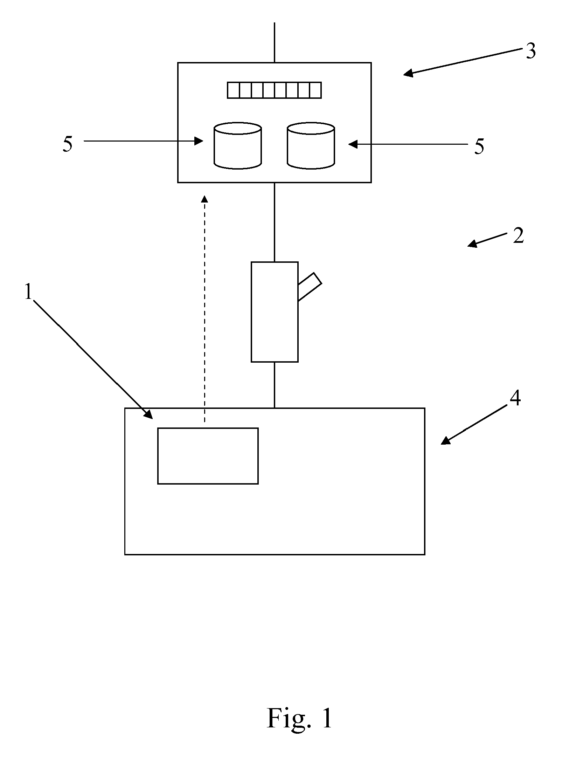

- la figure 1 montre un compteur électrique d'une installation dans laquelle se trouve un disjoncteur, ainsi qu'un équipement électrique branché en aval et comprenant un dispositif de suivi ;

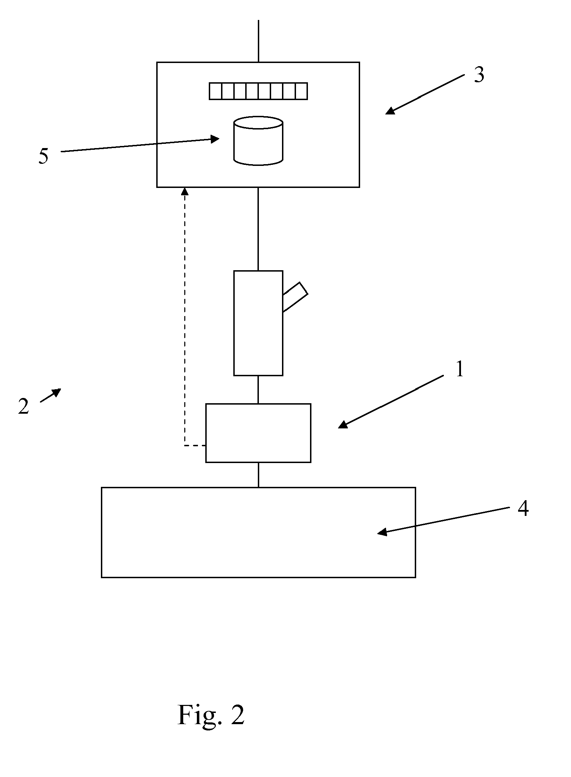

- la figure 2 montre un montage similaire mais où le dispositif de suivi est monté à l'extérieur de l'équipement consommateur ;

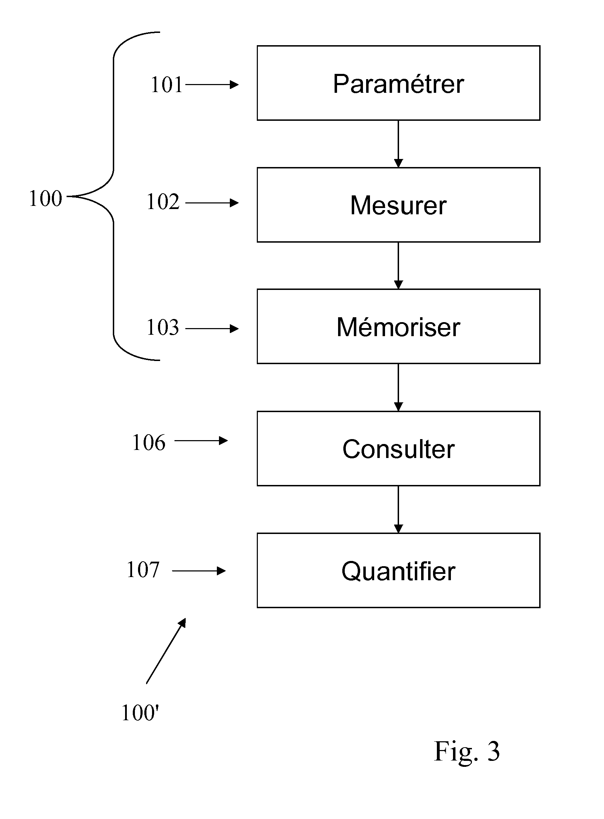

- la figure 3 montre un procédé de tarification comprenant un procédé de suivi selon l'invention.

L'invention a donc tout d'abord comme objet un dispositif de suivi 1 de la consommation d'énergie électrique dans une installation 2 électrique alimentée à partir du réseau, comprenant un compteur 3 ainsi que des équipements 4 électriques consommateurs branchés en aval de façon au moins temporaire, ledit compteur 3 étant apte à communiquer, avec ou sans fil, de sorte à au moins pouvoir recevoir une information.

L'installation 2 est de préférence une installation 2 électrique domestique, à laquelle l'énergie électrique est délivrée à partir d'un compteur 3 électrique, lui-même relié au réseau public. Classiquement, le compteur 3 mesure et mémorise la quantité d'énergie électrique totale consommée par l'installation 2. La quantité mémorisée est périodiquement relevée pour fixer un tarif total pour l'énergie consommée. L'installation 2 comprend aussi des équipements 4 électriques, essentiellement des consommateurs d'énergie électrique du type : luminaires, appareils électroménagers, outils électriques ou autre. Comme il sera décrit plus loin, un véhicule électrique peut aussi être considéré comme un équipement 4 électrique, branché temporairement dans l'installation 2 le temps d'une recharge. Ces équipements 4 peuvent donc être branchés en permanence dans l'installation 2, comme pour des appareils électroménagers, ou temporairement, comme pour des outils électriques.

Le compteur 3 central mesure et mémorise l'énergie électrique consommée par l'installation 2. Comme il sera encore décrit plus loin, la mémorisation peut se faire dans un ou plusieurs registres 5, chacun d'eux correspondant à un tarif utilisé pour la facturation ultérieure par le fournisseur d'énergie. Il est alors nécessaire de consulter séparément chacun de ces registres 5 pour définir le tarif global. La mémorisation peut aussi se faire dans un seul registre 5, dans lequel sont alors stockées, tant la quantité d'énergie elle-même qu'une information de tarif associée à cette quantité : indice tarifaire, tarif, surtarification, promotion, etc.

Le compteur 3 est aussi apte à communiquer, et donc au moins à recevoir une information, avec ou sans fil, comme par exemple une information représentant le tarif actuel de l'énergie électrique, ou encore les tarifs futurs et les heures de permutation d'un tarif à l'autre. L'information reçue peut donc servir à paramétrer le compteur 3. Le compteur 3 peut aussi avoir une fonction d'émission d'information, permettant par exemple de relever à distance la consommation mémorisée. L'échange d'information, avec l'installation 2, en aval, ou avec le réseau fournisseur, en amont, peut se faire avec une communication radiofréquence ou encore grâce à une communication filaire, préférentiellement par courant porteur.

Selon l'invention, le dispositif de suivi 1 comprend un émetteur de signal pour communiquer avec le compteur 3 et fournir une information de consigne tarifaire au compteur 3 électrique,
ledit dispositif étant destiné à être placé dans l'installation 2, au moins temporairement, en aval dudit compteur 3.

Le dispositif de suivi 1 est donc apte à émettre un signal que peut recevoir le compteur 3, ces deux éléments étant donc aptes à communiquer, au moins dans le sens de l'émission par le dispositif de suivi 1 et de la réception par le compteur 3. L'information transmise du dispositif de suivi 1 au compteur 3 est au moins une information de consigne tarifaire, et il peut donc s'agir, comme il sera décrit plus loin, d'une information ayant pour effet de changer le registre 5 de mémorisation de l'énergie consommée, lorsque le compteur 3 a plusieurs registres 5 de mémorisation, ou d'une information cumulant tant la quantité d'énergie que le tarif à y associer, lorsque le compteur 3 a un seul registre 5 de mémorisation, ou encore une information à mémoriser et représentant le tarif qui devra être associé à l'énergie mesurée ultérieurement par le compteur 3 : pourcentage d'une tarification normale, niveau qualitatif de tarification, ou autre.

Cette information de consigne tarifaire permet donc de définir le tarif qui devra être appliqué à une certaine quantité d'énergie mesurée et mémorisée par le compteur 3.

Une information de consigne tarifaire peut actuellement être envoyée à partir du réseau électrique alimentant l'installation 2. Ce signal est alors envoyé au compteur 3 par courant porteur ou encore par une transmission sans fil, comme dans US20090163136. Une telle information permet de paramétrer le compteur 3 pour la facturation ultérieure réalisée par le fournisseur d'électricité. Un tel paramétrage ne permet toutefois pas de tenir compte de l'utilisation de l'énergie dans l'installation 2. Ainsi, grâce à l'invention, c'est le dispositif de suivi 1 lui-même, placé dans l'installation 2, en aval du compteur 3 central, qui lui envoie une information de consigne tarifaire. Il est ainsi possible de définir le prix total de l'énergie non plus uniquement en fonction d'un paramétrage effectué par le réseau public d'alimentation, mais en fonction d'un paramétrage dépendant de l'utilisation faite de l'énergie dans l'installation 2, le dispositif de suivi 1 étant en effet branché en aval du compteur 3 central, formant un des éléments d'un équipement 4 électrique consommateur ou surveillant la consommation d'un tel équipement 4.

S'il est directement intégré à un des équipements 4 électriques de l'installation 2, le dispositif de suivi 1 fait alors partie des consommateurs électriques de l'installation 2. Il peut ainsi s'agir d'un dispositif de suivi 1 intégré dans un chargeur de véhicule électrique, ledit chargeur étant monté dans le véhicule lui-même, préférentiellement au niveau du socle présent sur le véhicule. Ainsi, si le dispositif de suivi 1 fait partie intégrante d'un équipement 4 électrique branché dans l'installation 2, il émet alors, dès que l'équipement 4 fonctionne, une information de consigne tarifaire à destination du compteur central 3.

Alternativement, si le dispositif de suivi 1 n'est pas un consommateur d'énergie de l'installation 2, comme un socle de branchement pour transmettre de l'électricité, il peut former un appareillage électrique capable de détecter une circulation de courant à destination d'un équipement 4 consommateur, et d'émettre alors un signal qui sera reçu par le compteur 3. Un tel dispositif de suivi 1 peut par exemple être installé pour surveiller, dans l'installation 2, une ligne électrique dédiée à un équipement 4 électrique particulier, comme un véhicule électrique à recharger. La détection de courant peut se faire à l'aide d'un tore ou d'un détecteur par effet Hall, par exemple.

Le dispositif de suivi 1 peut aussi consister essentiellement en un compteur particulier branché en aval du compteur 3 central, voire en un socle de branchement particulier. Il est en effet possible d'envisager que le dispositif de suivi 1 consiste essentiellement en un socle mural de branchement, ce dernier envoyant un signal dès lors qu'il détecte l'enfichage d'une prise de courant particulière, par exemple comme dans DE 20 2008 009929.

On notera que, dans tous les cas, le signal émis par le dispositif de suivi 1 peut être à destination d'un compteur 3 qui n'est pas le point d'entrée de l'énergie électrique dans l'installation 2.

Selon une caractéristique additionnelle possible, le dispositif de suivi 1 est apte à émettre une information permettant de faire commuter le compteur 3 d'un premier mode de tarification, où la quantité d'énergie consommée est mémorisée dans un premier registre 5, à un autre mode de tarification, où la quantité d'énergie consommée est mémorisée dans un autre registre 5, cet autre registre 5 pouvant être propre à l'équipement 4, comme un registre spécial pour recharge de véhicule électrique, ou un registre propre à un certain tarif, indépendamment de l'orgine de ce tarif particulier : plage horaire ou type d'équipement 4. Il est aussi envisageable que cette information englobe aussi une information d'identification de l'équipement 4 électrique particulier.

Dans ces cas, le compteur 3 central est donc tel que la réception d'un signal particulier a pour effet de commuter le registre 5 dans lequel la consommation d'énergie est mesurée. Ce principe est utilisée dans plusieurs pays dont la France pour différencier des tarifs heures pleines / heures creuses. Ici, il est proposé que la commutation ait lieu suite à une action d'un appareil électrique en aval du compteur 3. Comme il sera décrit plus loin, le signal peut être envoyé directement par courant porteur en ligne.

En outre, dans le cas particulier où le dispositif de suivi 1 est monté dans un véhicule électrique, formant alors un équipement 4, branché temporairement dans l'installation 2, à savoir lors des moments de recharge, il peut être particulièrement intéressant que le dispositif de suivi 1 envoie un signal qui forme, d'une part, l'information de consigne tarifaire, qui peut par exemple provoquer une commutation du registre 5 ou qui peut compléter l'information de mesure mémorisée dans un seul registre 5, et, d'autre part, une information d'identification de l'équipement 4, à savoir du véhicule électrique particulier. Il est alors envisageable de mémoriser, au niveau du compteur 3, la quantité d'énergie consommée pour la recharge de chaque véhicule séparément, ce qui permet donc d'envisager une installation électrique partagée par plusieurs utilisateurs, chacun rechargeant son propre véhicule électrique, la facturation finale permettant d'identifier séparément l'énergie consommée par chaque véhicule. L'installation 2 peut alors être une installation publique, accessible à un ensemble d'abonnés.

L'information de consigne tarifaire, envoyée par le dispositif de suivi 1, est donc complétée par une signature d'identification de l'équipement 4 lui-même. Ainsi, de façon générale, le dispositif de suivi 1 peut être apte à émettre, à destination du compteur 3 central, une information de consigne tarifaire accompagnée d'une information qui permet l'identification dudit dispositif, et/ou de l'équipement 4 qu'il surveille ou dans lequel il est monté. Il convient de remarquer que la signature, permettant d'identifier le dispositif de suivi 1, et a fortiori l'éventuel équipement 4 dans lequel il est monté, peut aussi être utilisée directement comme consigne tarifaire, puisque le compteur 3 peut la décoder et y associer, grâce à une logique qui lui est propre, une consigne de tarif, qui aura, par exemple, pour effet de commuter le registre 5 du compteur 3 comme il a déjà été évoqué. Ainsi, si la signature correspond à celle d'un chargeur de véhicule électrique, il est possible de mémoriser directement l'énergie électrique consommée et le tarif associé à une recharge de véhicule. Il est donc possible, dans certaines réalisations particulières, d'affecter un tarif différent à certains véhicules électriques, en fonction de conditions commerciales négociées ou tarifées différemment pour chacun. Un tarif encore différent pourra bien sûr être appliqué si la signature correspond à un équipement de chauffage, un équipement électroménager ou un équipement audiovisuel.

Selon une caractéristique additionnelle possible, le dispositif de suivi 1 comprend un modem émetteur de signal par courant porteur en ligne, apte à envoyer par courant porteur, et à destination du compteur 3, l'information de consigne tarifaire. Ce modem permet donc d'envoyer le signal au compteur 3 central par le câblage de l'installation 2. Alternativement, il peut s'agir d'un modem émetteur sans fil, apte à envoyer sans fil, et à destination du compteur 3 central, l'information de consigne tarifaire.

A titre d'exemple, un dispositif de suivi 1 peut donc prendre la forme d'un détecteur de courant, installé sur une ligne dédiée à la recharge d'un véhicule électrique, et qui, dès qu'un courant est détecté, envoie sans fil une information de consigne tarifaire au compteur 3. Une telle réalisation peut être aisément rajoutée dans une installation 2 existante, sans modifier les appareils présents ni exiger une profonde modification du câblage.

Il peut aussi s'agir d'un socle, destiné au branchement d'un câble de recharge d'un véhicule électrique, et qui émet un signal, par courant porteur sur les lignes fournissant la puissance électrique, à destination du compteur 3, lorsqu'une fiche électrique ou qu'une circulation d'électricité est détectée.

Le dispositif de suivi 1 selon l'invention peut donc aussi être un des appareillages électriques transmettant l'énergie électrique depuis le compteur 3 jusqu'à un équipement 4 électrique consommateur particulier, par exemple un socle de branchement, ou encore une rallonge pour brancher un véhicule électrique à une borne de recharge.

Il peut aussi s'agir d'un compteur dédié à une ligne électrique particulière de l'installation 2, mesurant la quantité d'énergie qui y circule, et qui envoie une information représentative de cette quantité d'énergie consommée à destination du compteur 3, ce dernier la stockant en y associant une consigne tarifaire propre à la ligne surveillée.

L'invention a aussi pour objet un équipement 4 électrique, destiné à être branché et alimenté temporairement ou de façon permanente dans une installation 2, notamment chargeur de véhicule électrique, véhicule électrique, appareil électroménager, équipement de chauffage, ou encore luminaire. L'équipement 4 électrique est donc un appareil qui consomme de l'énergie électrique fournie par l'installation 2. Sa consommation est donc relevée par le compteur 3 central.

Selon l'invention, cet équipement 4 comprend un dispositif de suivi 1 tel que décrit ci-dessus. L'équipement 4 électrique, destiné à être monté, dans l'installation 2, en aval du compteur 3 central, a donc une fonction de paramétrage dudit compteur 3, permettant de définir le tarif qui doit être associé à l'énergie consommée, en particulier à l'énergie consommée par l'équipement 4 électrique. En particulier, il est envisageable que l'information de consigne tarifaire émise soit propre à la nature, au type, et donc à la fonction de l'équipement 4 électrique : appareil de chauffage électrique, appareil électroménager, véhicule électrique, luminaire, etc. Préférentiellement, on considérera que les équipements 4 sont de types différents dès lors qu'il peut être pertinent d'y associer des tarifs différents.

L'équipement 4 électrique, dès lors qu'il consomme de l'électricité dans l'installation 2, peut donc envoyer une information de consigne tarifaire à destination du compteur 3, permettant alors au compteur d'associer un tarif particulier à l'électricité consommée pendant tout le fonctionnement de l'équipement 4 électrique.

Dans des modes de réalisation possibles, l'équipement 4 électrique prend la forme d'un chargeur de batteries pour véhicule électrique, monté dans ledit véhicule, le dispositif de suivi 1 étant alimenté en courant continu par la batterie du véhicule, dès lors qu'elle est suffisamment chargée. Le dispositif de suivi 1 fait alors partie du chargeur du véhicule électrique, et il est préférentiellement alimenté électriquement par la batterie du véhicule, dès lors que celle-ci est suffisamment chargée. Il peut aussi tirer son énergie directement du câble de recharge, en amont de sa fourniture aux batteries. Le dispositif de suivi 1 émet alors, par courant porteur en ligne, un signal, qui pourra être reçu par le compteur 3 central, ce dernier pouvant alors associer à l'énergie qu'il mesure un tarif propre à la recharge d'un véhicule électrique.

Le dispositif de suivi 1 peut ainsi émettre en continu, tant que la consommation a lieu, et le compteur 3 revient à un mode tarifaire normal dès lors que l'émission de ce signal prend fin, à savoir lorsque la consommation est terminée. Alternativement, le dispositif de suivi 1 peut, au début de la recharge, émettre un signal qui fera passer le compteur 3 à un mode d'enregistrement de la consommation propre à la recharge d'un véhicule électrique, puis, à la fin de la recharge, émettre un nouveau signal qui annulera la précédente consigne et fera passer le compteur 3 à un mode d'enregistrement différent, souvent un mode d'enregistrement normal. Si le dispositif de suivi 1 émet en permanence, le compteur 3 peut enregistrer en permanence l'énergie consommée et un tarif à y associer, et, dans le cas contraire, si le dispositif de suivi 1 émet de façon ponctuelle, le compteur 3 peut enregistrer un signal modifiant le tarif à associer à l'énergie qui sera ultérieurement consommée.

L'invention a aussi pour objet un procédé de suivi 100 de la consommation d'énergie électrique dans une installation 2 électrique alimentée à partir du réseau, comprenant un compteur 3 ainsi que des équipements 4 électriques consommateurs branchés en aval de façon au moins temporaire, ledit compteur 3 étant apte à communiquer, avec ou sans fil, de sorte à au moins pouvoir recevoir une information, le procédé comprenant
- une étape de paramétrage 101, consistant essentiellement à fournir une information de consigne tarifaire au compteur 3 électrique,
- une étape de mesure 102 consistant essentiellement à mesurer la quantité d'énergie électrique consommée, et
- une étape de mémorisation 103, consistant essentiellement à mémoriser au moins la consommation mesurée au niveau du compteur 3.

Comme il a déjà été dit, la mémorisation 103 se fait dans un ou plusieurs registres 5, et, dans l'art antérieur, le paramétrage 101 se fait grâce à un appareil en amont du compteur 3, qui lui fournit donc l'information nécessaire pour appliquer un tarif défini par le fournisseur d'énergie.

Selon l'invention, l'information de consigne tarifaire est fournie au compteur 3 électrique depuis l'aval de l'installation 2, notamment par un dispositif de suivi 1 tel que décrit ci-dessus, ou encore par un des équipements 4 électriques alimentés par l'installation 2 et comprenant un tel dispositif. Cela permet donc, comme il a déjà été dit, d'adapter le tarif appliqué à l'énergie électrique non pas simplement en fonction de tranches horaires définies par une centrale placée en amont du compteur 3 sur le réseau d'alimentation, mais en fonction du type d'équipement 4 électrique auquel l'énergie électrique est destinée. C'est donc depuis l'aval du compteur 3 qu'est envoyée une information de consigne tarifaire au compteur 3, dans le but de réaliser le paramétrage 101 dudit compteur 3, indépendamment d'une éventuelle consigne tarifaire envoyée par une centrale amont, les deux consignes tarifaires pouvant par exemple s'additionner : une première surtarification peut ainsi être appliquée pour des équipements 4 d'un type particulier, comme des luminaires, grâce à la présence d'un dispositif de suivi 1, à laquelle une deuxième surtarification peut être appliquée compte tenu de leur utilisation au cours de périodes horaires de surtarification, définies par la centrale amont au compteur 3.

Cette information de consigne tarifaire peut provenir d'un équipement 4 électrique consommateur alimenté par l'installation 2 et comprenant un dispositif de suivi 1 tel que décrit, ou encore par un tel dispositif de suivi 1 monté dans l'installation 2.

L'information de consigne tarifaire peut être uniquement représentative du type d'équipement 4, l'association entre le type d'équipement 4 et un tarif monétaire étant faite ultérieurement, ou directement représentative du tarif monétaire lui-même, ou d'une tranche, ou encore d'un pourcentage de surtarification par rapport à un tarif de référence, par exemple.

Selon une caractéristique additionnelle possible, le procédé de suivi 100 comprend, en outre, une étape consistant essentiellement à changer, au niveau du compteur 3 central, le registre 5 de mémorisation de la quantité d'énergie consommée, et ce sur la base de l'information de consigne tarifaire, l'information de consigne tarifaire, fournie au compteur 3 électrique, permettant de faire commuter le compteur 3 d'un premier mode de tarification, où la quantité d'énergie consommée est mémorisée dans un premier registre 5, à un autre mode de tarification, où la quantité d'énergie consommée est mémorisée dans un autre registre 5. Dans ces cas, le compteur 3 est du type à posséder au moins deux registres 5 de mémorisation de la quantité d'électricité consommée, et le paramétrage 101 revient à définir le registre 5 dans lequel la consommation relevée doit être mémorisée.

Selon une caractéristique additionnelle possible, l'étape de mémorisation 103 revient à mémoriser, de façon associée, d'une part, la quantité d'énergie consommée, et, d'autre part, la consigne tarifaire associée à ladite consommation d'énergie. Dans ces cas, le compteur 3 mémorise la quantité d'électricité consommée à l'aide d'un seul registre 5, et il est alors possible de mémoriser simultanément une quantité d'énergie consommée ainsi qu'une information de consigne tarifaire à y associer. Bien entendu, la consigne tarifaire mémorisée en même temps que la quantité d'énergie associée peut être : le type d'équipement 4, la signature identifiant un équipement 4 spécifique parmi une flotte possible, comme pour un parc de véhicules électriques, un pourcentage de surtarification ou soustarification par rapport à un tarif de base, un niveau de tarification, un tarif monétaire, etc.

Comme le paramétrage 101, sous l'effet d'un signal émis depuis l'installation 2 en aval du compteur 3, agit directement au niveau dudit compteur 3, le tarif à associer à l'équipement 4 sera alors aussi appliqué à toute la consommation des appareils branchés en aval du compteur 3, et donc aussi à d'autres équipements 4 de l'installation 2 qui consomment simultanément de l'énergie électrique. Il se peut alors, par exemple, qu'une consigne de surtarification, reçue par la présence, en aval, d'un type d'équipement 4 auquel cette surtarification doit être appliquée, comme un chargeur de véhicule électrique, soit aussi appliquée par erreur à la consommation d'un équipement 4 d'un type différent, auquel aucune surtarification ne doit être appliquée, par exemple un appareil électroménager ou un téléviseur. Il peut donc être nécessaire d'identifier, dans la consommation globale de l'installation 2, relevée au niveau du compteur 3 électrique, la consommation effectivement propre à l'équipement 4 électrique qui a fourni la consigne tarifaire.

Ainsi, selon une caractéristique additionnelle possible du procédé de suivi 100, il comprend, en outre, une étape consistant à analyser la consommation d'énergie électrique, de sorte à en identifier la portion effectivement consommée par un équipement 4 électrique qui a fourni au compteur 3 l'information de consigne tarifaire. Cette analyse, qui peut être effectuée par le dispositif de suivi 1 ou par le compteur 3, peut consister essentiellement à analyser sa variation dans le temps de sorte à détecter une augmentation significative de la consommation puis une baisse du même ordre de grandeur, cette surconsommation temporaire pouvant alors être considérée comme la portion consommée par l'équipement 4 électrique qui a fourni l'information de consigne tarifaire.

Dans le cas où l'information de consigne tarifaire définit aussi le type d'équipement 4 électrique, il est alors possible de connaître le profil standard de consommation provoquée par cet équipement 4 électrique, en particulier s'il s'agit d'un chargeur de véhicule automobile et de surveiller la consommation électrique de sorte à identifier un tel profil. En effet, un tel équipement consomme classiquement une intensité proche de 10 Ampères, et ce pendant environ 8 heures. Il est donc possible de détecter, au niveau du compteur 3, l'augmentation soudaine de l'ampérage avec une valeur d'environ 10 Ampères, puis sa stabilisation et sa diminution à la fin de la charge. La réception d'une information de consigne tarifaire provenant d'un équipement 4, chargeur de véhicule électrique, la détection d'un front montant d'une amplitude correspondant sensiblement à celle d'une recharge, la détection d'un front descendant correspondant, ainsi que le temps séparant ces deux fronts, permettent d'avoir une évaluation de l'énergie effectivement consommée par la recharge du véhicule.

Il est aussi possible de détecter l'équipement 4 électrique, lors de sa mise en marche puis de son extinction, par l'effet provoqué sur la ligne électrique, par exemple comme envisagé dans EP 1 136829, sous la forme de l'impulsion électrique parasite haute fréquence créée dans l'installation 2 par l'équipement 4. Il est ainsi possible à un dispositif de suivi 1 de détecter une mise en circuit puis hors circuit d'un équipement 4 électrique particulier, comme un chargeur de véhicule électrique, puis d'envoyer une information de consigne tarifaire à destination du compteur 3, dépendant par exemple de la nature, du type, de l'équipement 4 électrique qu'il aura pu déduire du phénomène électrique observé sur la ligne.

Dans des modes de réalisation particuliers, l'étape de paramétrage 101 est réalisée par le biais d'une communication par courant porteur, en utilisant les lignes de puissance entre le dispositif de suivi 1 envoyant cette information et le compteur 3. Le câblage permettant de fournir la puissance électrique à l'équipement 4 électrique, et/ou le dispositif de suivi 1 est donc réutilisé pour envoyer le signal au compteur 3. Alternativement, le paramétrage 101 peut être réalisé par le biais d'une communication sans fil.

Selon une caractéristique additionnelle possible, l'information de consigne tarifaire englobe aussi une information d'identification de l'équipement 4 électrique particulier, cette identification permettant de distinguer un équipement 4 électrique d'un autre du même type, dans le but de ventiler différemment la facturation associée, comme il a déjà été présenté plus haut.

L'invention a aussi pour objet un procédé de tarification 100' de la consommation d'énergie électrique dans une installation 2 électrique alimentée à partir du réseau, comprenant un compteur 3 ainsi que des équipements 4 électriques consommateurs branchés en aval de façon au moins temporaire, ledit compteur 3 étant apte à communiquer, avec ou sans fil, de sorte à au moins pouvoir recevoir une information, le procédé comprenant
- une étape de consultation 106 consistant essentiellement à relever l'information mémorisée par le compteur 3,
- une étape de quantification 107 consistant essentiellement à définir un prix total pour l'énergie consommée.

Le but de ce procédé de tarification 100' est, pour un fournisseur d'énergie électrique, d'associer un prix à facturer à une électricité consommée pour une installation électrique 2 et relevée par un compteur 3. Comme évoqué plus haut, classiquement, un prix fixe peut être associé à une unité d'énergie, ou le prix par unité d'énergie peut être dépendant des plages horaires. Lors de la consultation 106, le contenu du ou des registres 5 est relevé. Comme il a déjà été développé, le compteur 3 peut n'avoir qu'un seul registre 5 dans lequel l'énergie consommée est mémorisée, de préférence de façon associée à une information de tarif. Le compteur 3 peut aussi avoir plusieurs registres 5, chacun étant destiné à l'application d'un tarif par le fournisseur. Lors de la quantification 107, le prix total de l'énergie consommée est donc fixé en tenant compte de la consommation mémorisée ainsi que du tarif qui doit y être appliqué.

Selon l'invention, le prix défini par la quantification 107 tient compte du type d'équipement 4 électrique qui a consommé l'énergie. Ainsi, en complément d'une quantification 107 dépendant des créneaux horaires au cours desquels a lieu la consommation, il est proposé de tenir compte de l'équipement 4 électrique qui a consommé l'énergie, en particulier de son type : il peut s'agir d'électroménager, de chauffage électrique, de luminaire, ou encore d'un véhicule électrique à recharger, et chaque type d'équipement 4 aura son tarif.

Dans des modes de réalisation particuliers, le procédé de tarification 100' comprend, d'une part, une étape consistant essentiellement à relever la quantité d'énergie circulant dans l'installation 2 au niveau d'une ligne électrique dédiée à un type d'équipement 4, comme à un chargeur de véhicule électrique, et, d'autre part, une étape consistant à transmettre au compteur 3 central une information représentant au moins ladite quantité d'énergie, notamment aussi le type d'équipement 4 auquel la ligne concernée est dédiée. Ainsi, l'installation 2 a une ligne électrique dédiée à un type particulier d'équipement 4, et on relève la quantité d'électricité qui circule dans cette ligne. L'information relevée est périodiquement envoyée au compteur 3, qui peut alors mémoriser spécifiquement cette mesure. Le compteur 3 peut alors avoir été paramétré pour associer lui-même une consigne de tarif à l'énergie mesurée et qui lui est transmise. Ce procédé de tarification 100' met donc en oeuvre un compteur dédié, communicant son relevé à un compteur 3 central, capable d'associer une consigne de tarif au relevé qu'il reçoit. L'information transmise peut aussi inclure un codage représentant le type d'équipements 4 utilisé par la ligne surveillée ou une information de consigne tarifaire à appliquer.

Ainsi, un socle électrique de branchement mural, conçu pour le branchement d'une fiche de recharge de véhicule électrique, peut intégrer un compteur d'électricité, qui envoie, à destination du compteur 3, l'information de la quantité d'énergie consommée. L'information est ensuite mémorisée par le compteur 3.

En outre, selon une caractéristique additionnelle possible, le procédé de tarification 100' comprend un procédé de suivi 100 tel que décrit plus haut, la quantification 107 étant effectuée à partir des informations mémorisées par le compteur 3, notamment à partir d'un même registre 5 dans lequel sont stockés tant la quantité d'énergie consommée que l'information de consigne tarifaire associée ou à partir de plusieurs registres 5, chacun d'eux étant propre à une consigne tarifaire et mémorisant une quantité d'énergie.

Enfin, selon une caractéristique additionnelle possible, la quantification 107 tient compte d'un identifiant propre à un équipement 4 particulier, permettant ainsi d'affecter des tarifs différents pour différents équipements 4 d'un même type, notamment de sorte à pouvoir tenir compte des conditions commerciales de fourniture pour un équipement 4 d'un même type, notamment des tarifs différents propres à chaque véhicule électrique particulier qui utilise du courant pour sa recharge.

Comme il a déjà été mentionné plus haut, cela permet, en particulier de traiter différemment des équipements 4 électriques d'un même type. Différents véhicules électriques peuvent donc être branchés dans une même installation, le tarif associé pour chacun d'eux dépendant aussi du contrat de fourniture qui est propre à chacun d'eux. Le tarif peut donc dépendre du type d'équipement 4, mais aussi, pour un même type, de l'équipement 4 lui-même et de l'abonnement de fourniture souscrit par son propriétaire. L'identifiant particulier pour un véhicule électrique peut par exemple être en lien avec son immatriculation. Chaque équipement 4 réel peut donc avoir son propre tarif.

Il est alors possible d'envisager que l'utilisateur de l'installation 2 ait deux véhicules électriques différents, l'un d'eux faisant l'objet d'une promotion par le fournisseur d'énergie, par exemple compte tenu d'accords commerciaux entre le fournisseur et le constructeur. On peut alors différencier chacun des deux véhicules et affecter un tarif différent à chacun d'eux, bien qu'ils soient branchés dans la même installation 2, et soient des équipements 4 du même type.

Il est aussi possible d'utiliser ce principe pour une recharge à partir d'une borne publique, qui pourra identifier chaque véhicule. A défaut de reconnaissance de l'identification comme étant celle d'un abonné, la fourniture d'énergie pourra être stoppée. La consommation propre à ce véhicule pourra ensuite être différenciée de la consommation d'un autre véhicule, la borne pouvant, grâce à la transmission d'un identifiant du véhicule, allouer la consommation relevée à un véhicule particulier, et donc un compte ou abonnement de fourniture préalablement enregistré. La facturation finale pourra ensuite être individuelle et propre à chaque véhicule.

Bien entendu, l'invention n'est pas limitée au mode de réalisation décrit et représenté aux dessins annexés. Des modifications restent possibles, notamment du point de vue de la constitution des divers éléments, par d'autres combinaisons des caractéristiques détaillées ci-dessus, ou par substitution d'équivalents techniques, sans sortir pour autant du domaine de protection de l'invention. En particulier, il est tout à fait envisageable que les principes développés et présentés ci-dessus soient généralisés au suivi d'une consommation d'un autre type d'énergie ou d'une consommation de substance, comme de l'eau, un carburant, du gaz, ou d'autres produits distribués, ladite consommation mettant en jeu une source pour la fourniture, type réseau public, ainsi qu'un appareil permettant de comptabiliser la consommation d'un ensemble d'appareils en aval.

## Revendications

1. Dispositif de suivi (1) de la consommation d'énergie électrique dans une installation (2) électrique alimentée à partir du réseau, l'installation comprenant un compteur (3) ainsi que des équipements (4) électriques consommateurs branchés en aval de façon au moins temporaire, ledit compteur (3) étant apte à communiquer, avec ou sans fil, de sorte à au moins pouvoir recevoir une information,
dispositif **caractérisé en ce qu'**il comprend un émetteur de signal pour communiquer avec le compteur (3) et fournir une information de consigne tarifaire au compteur (3) électrique,
ledit dispositif étant destiné à être placé dans l'installation (2), au moins temporairement, en aval dudit compteur (3) **caractérisé en ce qu'**il est apte à émettre une information permettant de faire commuter le compteur (3) d'un premier mode de tarification, où la quantité d'énergie consommée est mémorisée dans un premier registre (5), à un autre mode de tarification, où la quantité d'énergie consommée est mémorisée dans un autre registre (5).

2. Dispositif de suivi (1) selon la revendication 1, **caractérisé en ce qu'il** comprend un modem émetteur de signal par courant porteur en ligne, apte à envoyer par courant porteur, et à destination du compteur (3), l'information de consigne tarifaire.

3. Equipement (4) électrique, destiné à être branché et alimenté temporairement ou de façon permanente dans une installation (2), **caractérisé en ce qu'il** comprend un dispositif de suivi (1) selon l'une quelconque des revendications 1 à 2.

4. Equipement (4) électrique selon la revendication 3, **caractérisé en ce qu'il** prend la forme d'un chargeur de batteries pour véhicule électrique, monté dans ledit véhicule, le dispositif de suivi (1) étant alimenté en courant continu par la batterie du véhicule, dès lors qu'elle est suffisamment chargée.

5. Procédé de suivi (100) de la consommation d'énergie électrique dans une installation (2) électrique alimentée à partir du réseau, l'installation comprenant un compteur (3) ainsi que des équipements (4) électriques consommateurs branchés en aval de façon au moins temporaire, ledit compteur (3) étant apte à communiquer, avec ou sans fil, de sorte à au moins pouvoir recevoir une information, le procédé comprenant
- une étape de paramétrage (101), consistant essentiellement à fournir une information de consigne tarifaire au compteur (3) électrique,
- une étape de mesure (102) consistant essentiellement à mesurer la quantité d'énergie électrique consommée, et
- une étape de mémorisation (103), consistant essentiellement à mémoriser au moins la consommation mesurée au niveau du compteur (3),
l'information de consigne tarifaire étant fournie au compteur (3) électrique depuis l'aval de l'installation (2),
procédé **caractérisé en ce qu'**il comprend, en outre, une étape consistant essentiellement à changer, au niveau du compteur (3) central, le registre (5) de mémorisation de la quantité d'énergie consommée, et ce sur la base de l'information de consigne tarifaire, l'information de consigne tarifaire, fournie au compteur (3) électrique, permettant de faire commuter le compteur (3) d'un premier mode de tarification, où la quantité d'énergie consommée est mémorisée dans un premier registre (5), à un autre mode de tarification, où la quantité d'énergie consommée est mémorisée dans un autre registre (5).

6. Procédé de suivi (100) selon la revendication 5, **caractérisé en ce que** l'étape de mémorisation (103) revient à mémoriser, de façon associée, d'une part, la quantité d'énergie consommée, et, d'autre part, la consigne tarifaire associée à ladite consommation d'énergie.

7. Procédé de suivi (100) selon l'une quelconque des revendications 5 ou 6, **caractérisé en ce qu'**il comprend, en outre, une étape consistant à analyser la consommation d'énergie électrique, de sorte à en identifier la portion effectivement consommée par un équipement (4) électrique qui a fourni au compteur (3) l'information de consigne tarifaire.

8. Procédé de suivi (100) selon l'une quelconque des revendications 5 à 7, **caractérisé en ce que** l'étape de paramétrage (101) est réalisée par le biais d'une communication par courant porteur, en utilisant les lignes de puissance entre le dispositif de suivi (1) envoyant cette information et le compteur (3).

9. Procédé de suivi (100) selon l'une quelconque des revendications 5 à 8, **caractérisé en ce que** l'information de consigne tarifaire englobe aussi une information d'identification de l'équipement (4) électrique particulier.

10. Procédé de tarification (100') de la consommation d'énergie électrique dans une installation (2) électrique alimentée à partir du réseau, comprenant un compteur (3) ainsi que des équipements (4) électriques consommateurs branchés en aval de façon au moins temporaire, ledit compteur (3) étant apte à communiquer, avec ou sans fil, de sorte à au moins pouvoir recevoir une information, le procédé comprenant
- une étape de consultation (106) consistant essentiellement à relever l'information mémorisée par le compteur (3),
- une étape de quantification (107) consistant essentiellement à définir un prix total pour l'énergie consommée,
procédé **caractérisé en ce que** le prix défini par la quantification (107) tient compte du type d'équipement (4) électrique qui a consommé l'énergie, et **en ce qu'**il comprend un procédé de suivi (100) selon l'une quelconque des revendications 5 à 9, la quantification (107) étant effectuée à partir des informations mémorisées par le compteur (3).

11. Procédé de tarification (100') selon la revendication 10, **caractérisé en ce que** la quantification (107) tient compte d'un identifiant propre à un équipement (4) particulier, permettant ainsi d'affecter des tarifs différents pour différents équipements (4) d'un même type, notamment de sorte à pouvoir tenir compte des conditions commerciales de fourniture pour un équipement (4) d'un même type.

## Patentansprüche

1. Vorrichtung (1) zur Verfolgung des Verbrauchs von elektrischer Energie in einer elektrischen Installation (2), die von dem Netz versorgt wird, wobei die Installation einen Zähler (3) umfasst ebenso wie elektrische Verbrauchergeräte (4), die wenigstens zeitweise stromabwärts angeschlossen sind, wobei der Zähler (3) ausgelegt ist, drahtgebunden oder drahtlos zu kommunizieren, um wenigstens eine Information zu erhalten, wobei die Vorrichtung **dadurch gekennzeichnet ist, dass** sie einen Signalsender umfasst, um mit dem Zähler (3) zu kommunizieren und eine Tarifhinweisinformation an den elektrischen Zähler (3) zu liefern, wobei die Vorrichtung ausgelegt ist, wenigstens zeitweise in der Installation (2) stromabwärts des Zählers (3) angeordnet zu werden, **dadurch gekennzeichnet, dass** sie geeignet ist, eine Information zu senden, die es dem Zähler (3) ermöglicht, von einem ersten Tarifmodus, in dem die verbrauchte Energiemenge in einem ersten Register (5) gespeichert wird, in einen zweiten Tarifmodus, in dem die verbrauchte Energiemenge in einem anderen Register (5) gespeichert wird, umzuschalten.

2. Nachverfolgungsvorrichtung (1) nach Anspruch 1, **dadurch gekennzeichnet, dass** sie inline ein Signalsendemodem durch Trägerstrom umfasst, welches geeignet ist, die Tarifhinweisinformation über einen Trägerstrom in Richtung des Zählers (3) zu senden.

3. Elektrisches Gerät (4), ausgelegt, um in einer Installation (2) angeschlossen und zeitweise oder dauerhaft versorgt zu sein, **dadurch gekennzeichnet, dass** es eine Nachverfolgungsvorrichtung (1) nach einem der Ansprüche 1 bis 2 umfasst.

4. Elektrisches Gerät (4) nach Anspruch 3, **dadurch gekennzeichnet, dass** es die Form eines Batterieladegerätes für ein elektrisches Fahrzeug aufweist, welches in dem Fahrzeug montiert ist, wobei die Nachverfolgungsvorrichtung (1) dauerhaft von der Batterie des Fahrzeugs mit Strom versorgt wird, sobald diese ausreichend geladen ist.

5. Verfahren (100) zur Nachverfolgung des elektrischen Energieverbrauchs in einer elektrischen Installation (2), die von dem Netz versorgt wird, wobei die Installation einen Zähler (3) umfasst ebenso wie elektrische Verbrauchergeräte (4), die stromabwärts zumindest zeitweise angeschlossen sind, wobei der Zähler (3) geeignet ist, drahtgebunden oder drahtlos zu kommunizieren, um wenigstens eine Information zu erhalten, wobei das Verfahren umfasst
- einen Schritt der Parametrisierung (101), der im Wesentlichen darin besteht, eine Tarifhinweisinformation an den elektrischen Zähler (3) zu liefern,
- einen Schritt der Messung (102), der im Wesentlichen darin besteht, die verbrauchte elektrische Energiemenge zu messen, und
- einen Schritt der Speicherung (103), der im Wesentlichen darin besteht, wenigstens den gemessenen Verbrauch im Zähler (3) zu speichern, wobei die Tarifhinweisinformation stromabwärts von der Installation (2) an den Zähler (3) geliefert wird,
wobei das Verfahren **dadurch gekennzeichnet ist, dass** es darüber hinaus einen Schritt umfasst, der im Wesentlichen darin besteht, das Register (5) zum Speichern der verbrauchten Energiemenge auf der Ebene des zentralen Zähler (3) zu ändern, und zwar auf Basis der Tarifhinweisinformation, wobei die Tarifhinweisinformation, die an den elektrischen Zähler (3) geliefert wird, den Zähler (3) veranlasst, von einem ersten Tarifmodus, in dem die verbrauchte Energiemenge in einem ersten Register (5) gespeichert wird, in einen anderen Tarifmodus, in dem die verbrauchte Energiemenge in einem anderen Register (5) gespeichert wird, zu schalten.

6. Nachverfolgungsverfahren (100) nach Anspruch 5, **dadurch gekennzeichnet, dass** der Schritt des Speicherns (103) wiederkehrt, um in entsprechender Weise einerseits die verbrauchte Energiemenge und andererseits den mit der verbrauchten Energiemenge verbundenen Tarifhinweis zu speichern.

7. Nachverfolgungsverfahren (100) nach einem der Ansprüche 5 oder 6, **dadurch gekennzeichnet, dass** es darüber hinaus einen Schritt zum Analysieren des Verbrauchs an elektrischer Energie umfasst, um den Anteil zu identifizieren, welcher von einem elektrischen Gerät (4), welches an den Zähler (3) den Tarifhinweis geliefert hat, effektiv verbraucht wurde.

8. Nachverfolgungsverfahren (100) nach einem der Ansprüche 5 bis 7, **dadurch gekennzeichnet, dass** der Schritt der Parametrisierung (101) über den Umweg einer Kommunikation über einen Trägerstrom umgesetzt ist, indem die Leistungsleitungen zwischen der Nachverfolgungsvorrichtung (1), die diese Information schickt, und dem Zähler (3) verwendet werden.

9. Nachverfolgungsverfahren (100) nach einem der Ansprüche 5 bis 8, **dadurch gekennzeichnet, dass** die Tarifhinweisinformation auch eine Information zur Identifikation des speziellen elektrischen Geräts (4) beinhaltet.

10. Verfahren zur Preisfestsetzung (100') des elektrischen Energieverbrauchs in einer elektrischen Installation (2), die von dem Netz versorgt wird, umfassend einen Zähler (3) ebenso wie elektrische Verbrauchergeräte (4), die zumindest zeitweise stromabwärts angeschlossen sind, wobei der Zähler (3) ausgelegt ist, drahtgebunden oder drahtlos zu kommunizieren, um wenigstens eine Information zu erhalten, wobei das Verfahren umfasst
- einen Abfrageschritt (106), der im Wesentlichen darin besteht, die von dem Zähler (3) gespeicherten Informationen abzulesen,
- einen Quantifizierungsschritt (107), der im Wesentlichen darin besteht, einen Gesamtpreis für die verbrauchte Energie festzulegen,
wobei das Verfahren **dadurch gekennzeichnet ist, dass** der durch die Quantifizierung (107) festgelegte Preis die Art des elektrischen Geräts (4), das die Energie verbraucht hat, berücksichtigt und dass es ein Nachverfolgungsverfahren (100) nach einem der Ansprüche 5 bis 9 umfasst, wobei die Quantifizierung (107) auf Basis der von dem Zähler (3) gespeicherten Informationen durchgeführt wird.

11. Verfahren zur Preisfestsetzung (100') nach Anspruch 10, gekennzeichnet, dass die Quantifizierung (107) eine einem bestimmten Gerät (4) zugeordnete Kennung berücksichtigt, die es somit ermöglicht, verschiedene Tarife für verschiedene Geräte (4) des gleichen Typs zu verwenden, insbesondere um die wirtschaftlichen Lieferbedingungen für ein Gerät (4) des gleichen Typs zu berücksichtigen.

## Claims

1. Device (1) for monitoring the consumption of electric power in an electrical installation (2) supplied by the mains grid, the installation comprising a meter (3) as well as electrical consumer devices (4) connected downstream at least temporarily, said meter (3) being able to communicate, by landline or wirelessly, so that it can at least receive information,
the device being **characterised in that** it comprises a signal transmitter for communicating with the meter (3) and providing information about the pricing to the electric meter (3),
said device being designed to be fitted into the installation (2), at least temporarily, downstream of said meter (3), **characterised in that** it is able to transmit information which can switch the meter (3) from a first pricing mode, where the amount of power consumed is saved in a first directory (5), to another pricing mode where the amount of power consumed is recorded in another directory (5).

2. Monitoring device (1) according to claim 1, **characterised in that** it comprises a carrier current modem signal transmitter, which can transmit the pricing information by carrier current and to the meter (3).

3. Electrical equipment (4) designed to be connected and supplied temporarily or in a permanent manner in an installation (2), **characterised in that** it comprises a monitoring device (1) according to any one of claims 1 to 2.

4. Electrical equipment (4) according to claim 3, **characterised in that** it is in the form of a battery charger for an electric vehicle mounted in said vehicle, the monitoring device (1) being supplied with continuous current by the vehicle battery once it has been sufficiently charged.

5. Method for monitoring (100) the consumption of electric power in an electrical installation (2) supplied by the mains grid, the installation comprising a meter (3) as a well as electrical consumer devices (4) connected downstream at least temporarily, said meter (3) being able to communicate by landline or wirelessly, so that it can at least receive information, the method comprising
- a parameterization step (101), consisting essentially of providing pricing information to the electric meter (3),
- a measuring step (102), consisting essentially of measuring the amount of electrical power consumed, and
- a saving step (103), consisting essentially of saving at least the consumption measured in the meter (3),
the pricing information being provided to the electric meter (3) from downstream of the installation (2),
the method being **characterised in that** it also comprises a step consisting essentially of changing in the central meter (3) the directory (5) saving the amount of power consumed and on the basis of the pricing information the pricing information provided to the electric meter (3), making it possible to switch the meter (3) from a first pricing mode where the amount of power consumed is saved in a first directory (5) to another pricing mode where the amount of power consumed is saved in another directory (5).

6. Monitoring method (100) according to claim 5, **characterised in that** the saving step (103) saves, in an associated manner, on the one hand the amount of power consumed and on the other hand the pricing associated with said consumption of power.

7. Monitoring method (100) according to either claim 5 or claim 6, **characterised in that** it also comprises a step of analysing the consumption of electrical power, so as to identify the amount actually consumed by an electrical device (4) which has supplied pricing information to the meter (3).

8. Monitoring method (100) according to any one of claims 5 to 7, **characterised in that** the parameterisation step (101) is performed by carrier current communication, using power lines between the monitoring device (1) sending said information and the meter (3).

9. Monitoring method (100) according to any one of claims 5 to 8, **characterised in that** the pricing information also comprises information identifying the particular piece of electrical equipment (4).

10. Pricing method (100') for the electrical power consumption of an electrical installation (2) supplied by a mains network, comprising a meter (3) as well as electrical consumer devices (4) connected downstream at least temporarily, said meter (3) being able to communicate, by landline or wirelessly, so that it can at least receive information, the method comprising
- a consultation step (106) consisting essentially of acquiring the information saved in the meter (3),
- a quantification step (107) consisting essentially of defining a total price for the power used,
said method being **characterised in that** the price defined by the quantification (107) takes into account the type of electrical device (4) that has used the power and **in that** it comprises a monitoring device (100) according to any one of claims 5 to 9, the quantification (107) being performed using information saved in the meter (3).

11. Pricing method (100') according to claim 10, **characterised in that** the quantification (107) takes into account an identifier specific to a particular device (4), making it possible to thus allocate different rates to different devices (4) of the same type, in particular so as to take into account the commercial conditions relating to supplying a device (4) of the same type.
